# EUROPEAN PATENT SPECIFICATION

(11) **EP 0 523 271 B1**
(45) Date of publication and mention of the grant of the patent: **12.03.1997**
(21) Application number: 91112050.9
(22) Date of filing: 18.07.1991
(51) Int. Cl.: H01Q 23/00, H01Q 7/08, H03F 3/195, H04B 1/04

(54) **Circuit arrangement for antenna coupling**
Schaltungsanordnung zur Antennenankopplung
Arrangement d'un circuit pour couplage d'antenne

(43) Date of publication of application: 20.01.1993
(73) Proprietor: TEXAS INSTRUMENTS DEUTSCHLAND GMBH, 85356 Freising (DE)
(72) Inventor: Viereck, Bruno, D-8051 Marzling (DE)
(74) Representative: Schwepfinger, Karl-Heinz, Dipl.-Ing.

(56) References cited:
- EP-A- 0 087 841
- EP-A- 0 386 255
- EP-A- 0 394 714
- EP-A- 0 412 426
- US-A- 4 963 880
- ELECTRONICS & WIRELESS WORLD. vol. 96, no. 1653, July 1990, SUTTON GB pages 568 - 573; 'Current amplifiers from voltage op-amps'

## Description

The invention relates to a circuit arrangement for coupling an output of a push-pull end stage of an RF generator formed by isolated gate field-effect transistors to an antenna resonant circuit comprising a coil and a capacitor, the antenna resonant circuit being part of an interrogation device of a transponder system on the use of which a sinusoidally varying magnetic field is generated by the interrogation device by means of the antenna resonant circuit and is received by a responder device of the transponder system and can be utilized to generate supply energy for the responder device, the responder device sending back data stored therein to the interrogation device after generation of the supply voltage.

EP-A-0 301 127 discloses a transponder system which consists of an interrogation device and a responder device. The peculiarity of this transistor system resides in that the transponder device does not contain its own battery for furnishing the supply energy but generates its supply energy from an RF interrogation pulse which it receives from the interrogation device. The interrogation device transmits said RF interrogation pulse whenever it is to be determined whether a responder device is present within its action range. Thus, when the interrogation device transmits the RF interrogation pulse and a responder device is present within its function range, after receiving the RF interrogation pulse the responder device answers by sending back data stored therein. From the data the interrogation device can determine the identity of the responder device.

Since the responder device derives its energy from the RF interrogation pulse said pulse must be transmitted by the interrogation device with the highest possible energy. To achieve this, it is necessary for the antenna resonant circuit consisting of a coil and a capacitor in the interrogation device to be coupled with minimum possible losses to the end stage of the transmitting section in the interrogation device. DE-A-3,912,034 discloses coupling the antenna resonant circuit via a transformer to the end stage of the transmitting section of the interrogation device. The coupling transformer is however a relatively heavy and expensive component, the use of which should be avoided if possible, since the aim is to construct the interrogation device as hand appliance. The use of a transformer is moreover disadvantageous when it has a closed core because the coupling-in winding then does not contribute to the formation of the magnetic field to be generated by the antenna coil.

EP-A-0 412 426 discloses a self-oscillating burst mode transmitter including a push-pull end stage and an antenna resonant circuit consisting of a coil and a capacitor, wherein the antenna resonant circuit is coupled directly galvanically to the push-pull end stage. US-A-4,963,880 discloses an antenna system providing transmit and receive functions. In this system, too, the antenna resonant circuit, which is formed by a coil, a capacitor and a resistor during a transmit interval, is coupled directly galvanically to the push-pull end stage.

The invention is based on the problem of providing a circuit arrangement of the type outlined at the beginning with the aid of which a very low-loss coupling of the antenna resonant circuit to the end stage of the RF generator is possible.

This problem is solved according to the invention in that the antenna resonant circuit is coupled to the push-pull end stage as described in the characterizing part of the claim.

By the coupling via a capacitor, the magnitude of said capacitor a transformation can be achieved which effects that with low currents through the end stage a high resonance current can be achieved in the antenna resonant circuit, leading to a correspondingly strong magnetic field.

The invention will now be explained by way of example with the aid of the drawings, wherein:

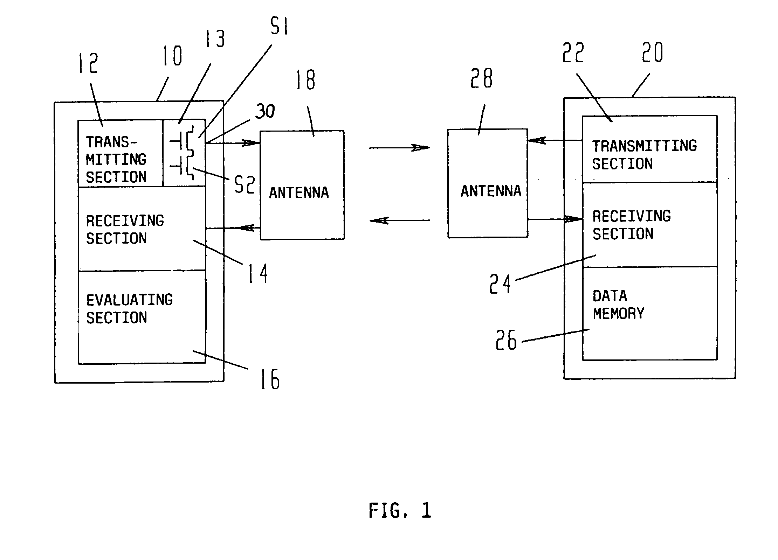

- Fig. 1: shows a schematic view of a transponder system for employing the circuit arrangement according to the invention,
- Fig. 2: shows an embodiment of the circuit arrangement according to the invention.

The transponder system illustrated in the drawings includes an interrogation device 10 which comprises a transmitting section 12 having a push-pull end stage 13, a receiving section 14 and an evaluating section 16. The push-pull end stage 13 includes as switches S1, S2 two isolated gate field-effect transistors. The transmitting section 12 and the receiving section 14 are coupled to an antenna 18. Furthermore, the arrangement includes a responder device 20 having a receiving section 24, a transmitting section 22 and a data memory 26. The receiving section 24 and the transmitting section 22 of the responder device 20 are coupled to an antenna 28.

The responder device 20 can be disposed on an article to which an identification number is allocated and said identification number is stored in the data memory 26. The content of the data memory 26 can be transmitted to the interrogation device 10 and evaluated by the evaluating section 16 thereof. It is possible in this manner to identify the article to which the responder device 20 is attached.

In detail, the following steps take place in the identification process:

After an operator has actuated a key switch, not shown, the interrogation device 10, which may be an appliance held in the hand by the operator, transmits by means of the antenna 18 an RF interrogation pulse generated in the transmitting section 12. The transmitted RF interrogation pulse is received by the antenna 28 of the responder device 20. Said antenna 28 consists of a coil forming together with a capacitor a resonant circuit tuned to the frequency of the RF interrogation pulse. The RF interrogation pulse received by the antenna 28 is rectified in the receiving section 24 and employed to charge a capacitor serving as energy accumulator from which after completion of the RF interrogation pulse the supply energy for the responder device 20 is derived. If after termination of the RF interrogation pulse the voltage present at said energy storage capacitor has a sufficiently high value, transmission of an RF signal via the antenna 28 is initiated in the responder device 20 and said signal is coded with the content of the data memory 26. Said coding may for example be achieved by a modulation of the RF signal. The RF signal radiated by the antenna 28 is received by the antenna 18 of the interrogation device 10 and supplied by the receiving section 14 thereof to the evaluating section 16 in which the RF signal is decoded. It is possible in this manner with the aid of the interrogation device 10 to read the contents of the data memory 26 so that from the decoded information an article to which the responder device 20 is attached can be uniquely identified.

The specific makeup of the interrogation device 10 and of the responder device 20 play only a secondary part in the method described here and can be seen from EP-A-0 301 127.

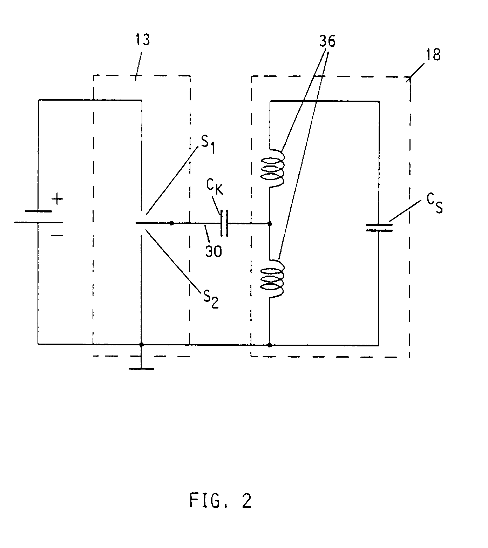

In Fig. 2 an embodiment of the circuit arrangement for coupling the antenna 18, or more exactly the antenna resonant circuit, to the push-pull end stage 13 is shown. The transmitting section 12 comprising the end stage 13 is shown only schematically, the field-effect transistors S1 and S2 of the end stage 13 each being shown as switches.

The field-effect transistors S1 and S2 are components which in the conductive state have only a very low impedance so that the dissipated loss in said field-effect transistors can almost be neglected.

In the circuit arrangement of Fig. 2 the coupling of the antenna resonant circuit is effected via a capacitor C_{K} which is inserted between the output 30 of the end stage 13 and a centre tap 34 of the coil 36 consisting of two identical parts. In this embodiment the capacitor C_{S} of the antenna resonant circuit lies in parallel with said coil 36.

The embodiment of Fig. 2 permits a particularly low-loss coupling because due to the capacitive coupling a capacitive transformation of the currents flowing in the resonant circuit on the one hand and in the end stage on the other also takes place and consequently only part of the resonant current flows through the end stage.

## Claims

1. Circuit arrangement for coupling an output of a push-pull end stage (13) of an RF generator (12) formed by isolated gate field-effect transistors (S1, S2) to an antenna resonant circuit (18) comprising a coil (36) and a capacitor (Cₛ), the antenna resonant circuit (18) being part of an interrogation device (10) of a transponder system on the use of which a sinusoidally varying magnetic field is generated by the interrogation device (10) by means of the antenna resonant circuit (18) and is received by a responder device (20) of the transponder system and can be utilized to generate supply energy for the responder device (20), the responder device (20) sending back data stored therein to the interrogation device (10) after generation of the supply voltage,
characterized in that
the antenna resonant circuit (18) is coupled to the push-pull end stage (13) via a reactance consisting of a capacitor (C_{K}) which is inserted between the output of the push-pull end stage (13) and a centre tap of the coil (36) in the antenna resonant circuit (18) to effect capacitive transformation.

## Patentansprüche

1. Schaltungsanordnung zum Koppeln eines Ausgangs einer von Feldeffekttransistoren (S1, S2) mit isoliertem Gate gebildeten Gegentakt-Endstufe (13) eines HF-Generators (12) mit einem Antennenschwingkreis (18) aus einer Spule (36) und einem Kondensator (Cₛ), wobei der Antennenschwingkreis (18) Teil eines Abfragegeräts (10) eines Transpondersystems ist, bei dessen Anwendung von dem Abfragegerät (10) mittels des Antennenschwingkreises (18) ein sich sinusförmig änderndes Magnetfeld erzeugt wird, das von einem Antwortgebergerät (20) des Transpondersystems empfangen und zur Erzeugung einer Versorgungsenergie für das Antwortgebergerät (20) ausgenutzt werden kann, wobei das Antwortgebergerät (20) nach Erzeugung der Versorgungsspannung in ihm gespeicherte Daten zu dem Abfragegerät (10) zurücksendet, dadurch gekennzeichnet, daß der Antennenresonanzkreis (18) mit der Gegentakt-Endstufe (13) über einen von einem Kondensator (C_{K}) gebildeten Blindwiderstand gekoppelt ist, der zwischen den Ausgang der Gegentakt-Endstufe (13) und eine Mittelanzapfung der Spule (36) in dem Antennenschwingkreis (18) zur Erzielung einer kapazitiven Transformation eingefügt ist.

## Revendications

1. Agencement de circuit pour coupler une sortie d'un étage d'extrémité push-pull (13) d'un générateur HF (12) formé par des transistors à effet de champ à grille isolée (S1, S2) à un circuit résonant d'antenne (18) comprenant une bobine (36) et un condensateur (C_{S}), le circuit résonant d'antenne (18) formant une partie d'un dispositif d'interrogation (10) d'un système à transpondeur au cours de l'utilisation duquel un champ magnétique variant de façon sinusoïdale est engendré par le dispositif d'interrogation (10) au moyen du circuit résonant d'antenne (18) et est reçu par un dispositif de réponse (20) du système à transpondeur et peut être utilisé pour engendrer une énergie d'alimentation pour le dispositif de réponse (20), le dispositif de réponse (20) renvoyant des données stockées dans celui-ci vers le dispositif d'interrogation (10) après la génération de la tension d'alimentation, caractérisé en ce que le circuit résonant d'antenne (18) est couplé à l'étage d'extrémité push-pull (13) à travers une réactance consistant en un condensateur (C_{K}) qui est inséré entre la sortie de l'étage d'extrémité push-pull (13) et une connexion centrale de la bobine (36) dans le circuit résonant d'antenne (18) pour effectuer une transformation capacitive.
